Europäisches Patentamt

European Patent Office

Office européen des brevets

(11) Veröffentlichungsnummer: **0 256 341 B1**

(12) **EUROPÄISCHE PATENTSCHRIFT**

(19)

(45) Veröffentlichungstag der Patentschrift: **16.12.92**

(21) Anmeldenummer: **87110638.1**

(22) Anmeldetag: **22.07.87**

(51) Int. Cl.⁵: **H02H 3/38,** H02H 3/42, H02H 7/26

(54) **Anordnung zur Schnellerkennung von Kurzschlüssen.**

(30) Priorität: **04.08.86 DE 3626400**

(43) Veröffentlichungstag der Anmeldung:
**24.02.88 Patentblatt 88/08**

(45) Bekanntmachung des Hinweises auf die
Patenterteilung:
**16.12.92 Patentblatt 92/51**

(84) Benannte Vertragsstaaten:
**AT BE CH DE FR GB IT LI NL SE**

(56) Entgegenhaltungen:
**DE-A- 3 132 730**
**US-A- 3 984 737**
**US-A- 4 300 182**

**ELEKTROTECHNISCHE ZEITSCHRIFT E.T.Z.-A,
Band 94, Nr. 4, April 1973, Seiten 216-220; R.
FOERST: "Methoden zur dynamischen Sicherheitsüberwachung elektrischer Netze"**

**IEEE TRANSACTIONS ON POWER APPARA-
TUS & SYSTEMS, Band 91, Mai 1972, Seiten
1235-1240; G.B. GILCREST et al.: "High-speed
distance relaying using a digital computer"**

(73) Patentinhaber: **SIEMENS AKTIENGESELL-
SCHAFT
Wittelsbacherplatz 2
W-8000 München 2(DE)**

(72) Erfinder: **Trenkler, Gerhard, Prof. Dr.
Am Weissen Kamp 7d
W-3300 Braunschweig(DE)**
Erfinder: **Maier, Reinhard, Dr.
Anna-Herrmann-Strasse 54
W-8522 Herzogenaurach(DE)**
Erfinder: **Nippert, Thomas, Dipl.-Ing.
Holzmühlenstrasse 75a
W-2000 Hamburg 70(DE)**

EP 0 256 341 B1

**Beschreibung**

Die Erfindung bezieht sich auf eine Anordnung zur Erkennung von Fehlern und zur Erzeugung eines elektrischen Auslösebefehls mit einer elektronischen Meß- und Verarbeitungsanordnung für Stromwerte, die in einer Digital-Vergleichsschaltung mit vorbestimmbaren Grenzwerten verglichen den Auslösebefehl abgibt, wobei die Meßanordnung sowohl die zeitlichen Verläufe des Stromes als auch der Spannung des Netzes mißt.

Eine Anordnung der obengenannten Art ist aus der US-A-4 300 182 bekannt. Hier handelt es sich um ein Tarifierungssystem mit integrierter Schutzfunktion mit einer Verarbeitung im Zeitbereich.

Bei einer weiterhin bekannten Anordnung (DE-OS 26 09 654) wird lediglich der Strom erfaßt, so daß keine Aussagen über umgesetzte Leistung, Leistungsfaktor und sonstige Kenngrößen gemacht werden können, und auch von außen herangeführte Störungen können nicht ohne weiteres erfaßt werden.

Die US-A-39 84 737 behandelt eine Erkennung von Netzzustandsänderungen über den Vergleich der Leistungen der Netzgrundschwingung zu zwei unterschiedlichen Zeitpunkten. Der Vergleich mit einem vorbestimmten Wert erzeugt hier ein Ausgangssignal, das zum Schutz des Netzsystems ausgewertet werden kann.

Der vorliegenden Erfindung liegt die Aufgabe zugrunde, eine Anordnung der obengenannten Art zu schaffen, bei der unter Vermeidung der obengenannten Unzulänglichkeiten auch die Art der Verbraucher im Betriebszustand und deren Verhalten feststellbar ist. Dies wird auf einfache Weise dadurch erreicht, daß zur schnellen Erkennung von Kurzschlüssen eine Anordnung vorgesehen ist, die die zeitlichen Verläufe von Strom und Spannung in den zugehörigen Frequenzbereich überführt und daß eine Anordnung zur Filterung des gemessenen Stromes und der Spannung vor den folgenden Untersuchungen vorhanden ist, so daß die komplexen Impedanzen (20) und Leistungen (21) außerhalb der netzfrequenten Anteile ermittelt werden.

Es ist an sich eine Anordnung zur Beeinflussung eines Schaltgerätes in Abhängigkeit von Netzzustandsdaten durch eine Impedanzmeßeinrichtung mit einer Verarbeitungsstufe, die in Abhängigkeit von vorgegebenen Impedanzwerten die Einschaltung des Schaltgerätes blockiert, bekannt (DE-OS 33 47 209). Die hier vorgenommene Impedanzmessung gibt keine direkten Angaben über die umgesetzten Leistungen. Um zu erreichen, daß durch den allgemeinen Verlauf der Impedanz über der Frequenz die für die Impedanz kennzeichnenden Werte extrahiert werden und hinsichtlich ihrer Größe in Klassen eingeteilt werden können, ist es vorteilhaft, wenn eine Anordnung vorgesehen ist, die eine Identifikationsrechnung durchführt und eine Klassifizierung der elektrischen Parameter des Anlagenteils ausführt. Um eine zuverlässige, preiswerte Anordnung der obengenannten Art zu schaffen ist es von Vorteil, wenn eine Anordnung vorgesehen ist, die den Strom und die Spannung nach einer Filterung in digitale Zahlenfolgen umsetzt und die die folgenden Untersuchungen mit digital arbeitenden, elektrischen Funktionsbausteinen ausführt. Um eine verkürzte Auswertzeit zu erhalten ist es von Vorteil, wenn eine Anordnung vorgesehen ist, die die digitalen Zahlenfolgen in eine zeitliche Folge von Segmenten zerlegt. Um die zu den Segmenten gehörigen, einzelnen charakteristischen Parameter miteinander vergleichen zu können ist es von Vorteil, wenn eine Anordnung vorgesehen ist, die die Zahlenfolgen in eine zeitliche Abfolge von Segmenten mit einer jeweils gleichen Anzahl von Meßwerten zerlegt. Um eine Zuverlässigkeitsangabe der vorgeschalteten Meßwertverarbeitung zu erhalten ist es von Vorteil, wenn eine Anordnung vorgesehen ist, die für das jeweilige Segment eine Normierung auf verschwindenden arithmetischen Mittelwert ausführt. Die Verarbeitung der Meßwerte wird einfacher, wenn eine Anordnung vorgesehen ist, durch die eine den Meßwerten des Stromes und der Spannung proportionale Skalierung durchgeführt wird. Wird in einer Anordnung die Kreuzkorrelationsfunktion der gemessenen Spannung und des Stromes gebildet, so folgt hieraus ein Maß für die Ähnlichkeit der Signale des Stromes und der Spannung. Wird eine Anordnung vorgesehen, die das Maximum der Kreuzrelationsfunktion sowie dessen zeitliche Lage zur Klassifikation des Anlagenzustandes benutzt, so geben die zeitlichen Lagen quantifizierbare Parameter für den Anlagenzustand an, während die Kreuzrelationsfunktion ein allgemeines Maß hierfür darstellt. Eine einfache Methode, zeitliche Verläufe von Signalen in den Frequenzbereich umzusetzen, ergibt sich, wenn eine Anordnung vorgesehen ist, die die Fouriertransformierten der gemessenen Spannung und des Stromes bildet. Das konjugiert komplexe Produkt der Fouriertransformierten der Spannung und des Stromes ist ein Maß für die in der Anlage umgesetzte komplexe Leistung. Die Ermittlung des Betrages und der Phase einzelner Frequenzbereiche des Produktes können zur Klassifikation des Anlagenzustandes benutzt werden. Der Betrag und die Phase bilden eine quantifizierbare Größe für die in der Anlage umgesetzte Leistung hinsichtlich des Wertes und der Phasenlage einzelner Linien. Zur Klassifikation des Anlagenzustandes ist es weiterhin von Vorteil, wenn eine Anordnung vorgesehen ist, in der der komplexe Quotient der Fouriertransformierten der Spannung und des Stromes für die zueinandergehörigen Frequenzbereiche sowie der Betrag und die Phase einzelner Frequenzbereiche des Quotienten gebildet werden. Um Fehlabschaltungen durch äußere Störungen zu vermeiden ist es von Vorteil, wenn eine Anordnung vorgesehen ist, die abhängig von dem Netz überlagerten höherfrequenten Störspannungen und -ströme des Anlagenteiles die voreingestellten Parameter und Grenzwerte betriebsmäßig selbsttätig nachführt. Eine einfache Anpassung an sich ändernde Netzzustände, beispielsweise durch Einschaltung von weiteren Verbrauchern, kann herbeigeführt werden, wenn eine Anordnung vorgesehen ist, die abhängig von Netzzustandsänderungen die voreingestellten Parameter und Grenzwerte selbsttätig nachführt. Um die Auswertezeit möglichst kurz zu halten ist es von Vorteil, wenn mehrere digitale Funktionsbausteine zur parallelen Untersuchung der gemessenen Ströme und Spannungen vorhanden sind. Eine weitere Verkürzung der Auswertezeit ergibt sich, wenn die einzelnen Segmente sich zeitlich überlappen und gleichzeitig parallel untersucht werden. Eine einfache Kurzschlußfrüherkennung läßt sich erzielen, wenn eine Anordnung vorgesehen ist, die die zeitliche Abfolge der die einzelnen Segmente charakterisierenden Parameter auswertet. Hier ist beispielsweise an eine Hochrechnung aufgrund sich ändernder Differenzen gedacht.

Anhand der Zeichnung wird ein Ausführungsbeispiel gemäß der Erfindung beschrieben.

Es zeigen:

Fig. 1    schematisch einen durch einen Leistungsschalter geschützten Anlageteil mit n Abgängen und

Fig. 2    ein Signalverarbeitungsschema gemäß der Erfindung.

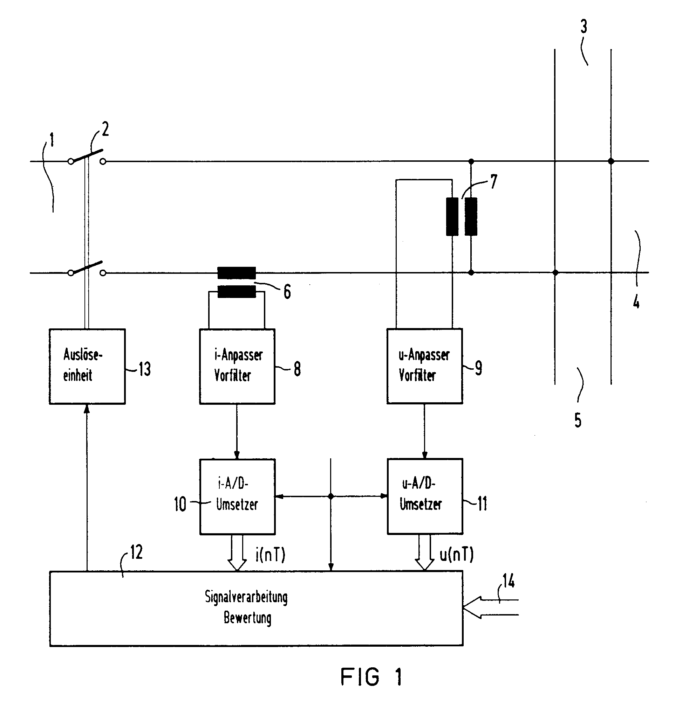

Die in der Fig. 1 dargestellte Niederspannungsverteilung ist an das Netz 1 über den Leistungsschalter 2 angeschaltet. Im Ausführungsbeispiel sind Verbraucher 3, 4 und 5 angedeutet. Der Strom i nach dem Leistungsschalter 1 wird über einen Stromwandler 6 und die Spannung u des Anlagenteiles über einen Spannungswandler 7 erfaßt. Die an die Sekundärseiten der Strom- bzw. Spannungswandler angeschlossenen Anordnungen 8 und 9 sorgen für die Anpassung der Pegel an die Aussteuerbereiche der nachfolgenden Analog-Digital-Umsetzer 10, 11. In den Anordnungen 8, 9 sind weiterhin Vorfilter vorgesehen, die einen Durchgang netzfrequenter Anteile in den übertragenen Spannungen und Strömen vermeiden sollen. Die Analog-Digital-Umsetzer 10, 11 stehen mit einer Signalverarbeitungsschaltung 12 in Verbindung, die ihrerseits auf einer Auslöseeinheit 13, die mit dem Leistungsschalter 2 in Verbindung steht, einwirkt. Der Leistungsschalter 2 kann auch ein elektronischer Schalter, beispielsweise ein Thyristor, sein. Die entsprechende Voreinstellung für die Signalverarbeitungsschaltung 12 ist durch einen Pfeil 14 angedeutet. In der Signalverarbeitungsschaltung 12 wird mittels einer oder mehrerer Speicher oder festprogrammierter Bauelemente eine Identifikation und Klassifizierung der hinter den Wandlern 6, 7 vorhandenen Anlagenzustände anhand von geeignet gewählten Parametern ausgeführt, wobei nach einem Vergleich mit den voreingestellten oder auch adaptiv nachgeführten Parametern nach Bewertung auf Kurzschluß erkannt und ein Befehl zum Auslösen des Leistungsschalters erzeugt wird.

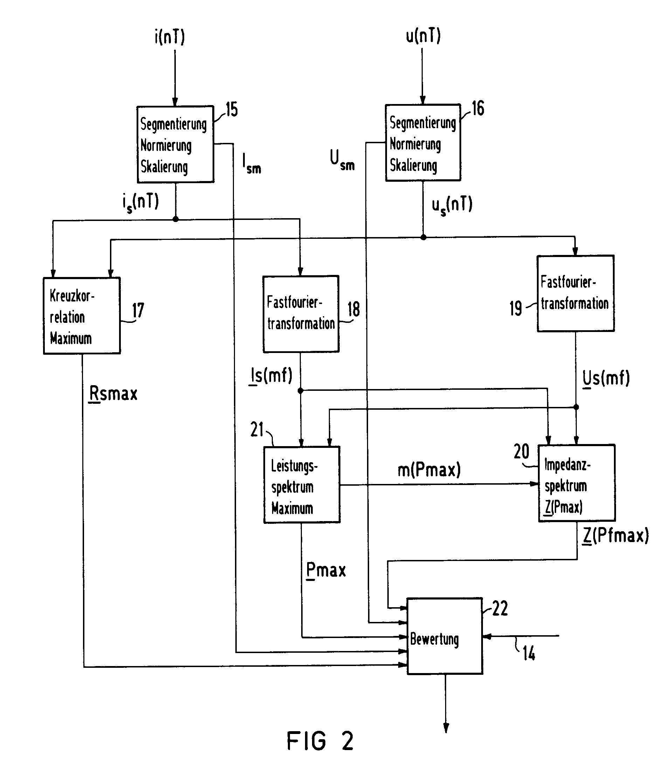

Eine mögliche Wirkungsweise der Signalverarbeitung 12 ist in Fig. 2 dargestellt, die nur geringe 'a priori'-Kenntnisse über die Anlage voraussetzt. Im ersten Schritt werden die digitalisierten Strom- und Spannungswerte i(nT), u(nT) in Zeitsegmente der Länge Tseg (etwa 30 us bis 100 us) gespalten, wobei die Anzahl der in einem Segment enthaltenen Werte ein ganzzahliges Vielfaches von zwei ist. Von den Wertefolgen innerhalb der einzelnen Segmente wird der arithmetische Mittelwert Ism bzw. Usm gebildet, die Wertefolgen durch Bildung von (i(nT)-Ism) bzw. (u(nT)-Usm) normiert und mit dem sich aus der bisher durchlaufenen Signalverarbeitungskette ergebenden Übertragungsfaktor skaliert.

Die Segmentierung, Normierung und Skalierung für Strom und Spannung sind durch die Kästen 15 und 16 angedeutet. Nähere Einzelheiten über die Segmentierung, Normierung und Skalierung sind dem Buch Brigham, Verlag Oldenburg, 2. Auflage, Seite 247 ff, zu entnehmen. Die segmentierten, normierten und skalierten Wertefolgen is(nT) bzw. us(nT) werden kreuzkorreliert und das Maximum und dessen Lage werden bestimmt. Ist der sich ergebende Wert für den Betrag von Rsmax kleiner als eine vorgegebene Schwelle, so kann ein Spannung und Strom gleichzeitig beeinflussendes Ereignis nach den Wandlern weitgehend ausgeschlossen werden, insbesondere, wenn die Lage des Maximums einen großen zeitlichen Abstand vom Nullpunkt der Kreuzkorrelationsfunktion hat. Die Kreuzkorrelation ist in Fig. 2 durch den Kasten 17 angedeutet und näher in dem Buch Brigham, Verlag Oldenburg, 2. Auflage, Seite 84 ff, beschrieben.

In einem weiteren Schritt werden die Wertefolgen is(nT) und us(nT) einer Fastfouriertransformation (FFT) unterworfen, so daß für die einzelnen Zeitsegmente die komplexen Amplitudenspektren Is(mf) und Us(mf) vorliegen. Nähere Einzelheiten der FFT sind dem Buch Brigham, Verlag Oldenburg, 2. Auflage, Seite 181 ff, zu entnehmen. Das konjugiert komplexe Produkt der beiden Wertefolgen ergibt das komplexe Leistungsspektrum P(mf), welches ein Abbild des Leistungsumsatzes des Anlagenteils nach den Wandlern ist. Nach Bestimmung der leistungsgrößten Linie oder auch des leistungshöchsten Frequenzbandes Pmax für die einzelnen Zeitsegmente kann durch Vergleich mit anlagespezifischen Werten auf Abweichungen nach Betrag und Phase vom normalen Anlagezustand geschlossen werden. Die Fastfouriertransformationsstufen für Strom und Spannung sind mit 18, 19 bezeichnet.

Ein Maß der Impedanz $\overline{Z}$ des auf die Wandler folgenden Anlagenteils während der aufeinanderfolgenden Zeitsegmente wird durch Bildung des Quotienten aus $\overline{Us}(mf)$ durch $\overline{Is}(mf)$ erhalten, siehe Bezugszahl 20, wobei man zweckmäßig den Bereich wählt, indem Pmax gefunden worden ist. Die Impedanzspektrumermittlung ist der Druckschrift Unbehauen, Verlag Springer, 2. Auflage, Seite 239 ff, zu entnehmen. Durch Vergleich der aus den Strom- und Spannungsverläufen berechneten Werte nach Betrag und Phase mit der spezifizierten Impedanz des Anlagenteils nach den Wandlern ist eine Unterscheidung von induktiv und kapazitiv wirkenden Verbrauchern, deren Zu- und Abschalten und einem ohmsch wirkenden Kurzschluß möglich. Da höherfrequente Spannungen und Ströme als Störungen der Netzspannung zu jedem Zeitpunkt überlagert sind, ist für die Bestimmung der Impedanz ein durch den Kurzschluß bewirkter transienter Strom- und Spannungsverlauf nicht zwingend erforderlich. Die das Leistungsspektrumsmaximum darstellende Stufe ist mit 21 bezeichnet. Die Ermittlungsmöglichkeiten des Leistungsspektrums sind der Veröffentlichung Stearns "Digitalsignal processing", Verlag Oldenburg, 1. Auflage, Seite 316 ff. zu entnehmen.

Die berechneten Werte für Ism, Usm, Rsmax, Pmax, Z(Pmax) werden zu einem Identifikationsvektor zusammengefaßt und klassifiziert. Die Bewertung durch Vergleich mit anlagespezifischen Werten aus der Voreinstellung führt zum Auslösebefehl für den Leistungsschalter oder zum Sperrbefehl für einen Thyristor. Weitere Verbesserungen der Arbeitsweise der Anordnung erhält man durch fortlaufende Anpassung der voreingestellten Vergleichswerte an normale Veränderungen des Anlagenzustandes und durch Bewertung der zeitlichen Abfolge der die einzelnen Segmente charakterisierenden Vektoren mit typisierten Verläufen. Die eigentliche Bewertungsschaltung ist mit 22 bezeichnet.

Eine schnelle Abarbeitung der o.a. Algorithmen der Signalverarbeitung und Bewertung erreicht man durch parallel laufende Bearbeitung der einzelnen Funktionsblöcke mit Hilfe einer Mehrfachanordnung von Prozessoren gegenüber der seriellen Bearbeitung mit nur einem Prozessor. Eine weitere Beschleunigung der Bearbeitung wird durch überlappende Segmentierung möglich, wenn ein erhöhter Aufwand in Kauf genommen wird; so kann z.B. bei vierfacher Überlappung die Rechenzeit auf ein Viertel verkürzt werden.

**Patentansprüche**

1. Anordnung zur Erkennung von Fehlern und zur Erzeugung eines elektrischen Auslösebefehls mit einer elektronischen Meß- und Verarbeitungsanordnung für Stromwerte, die in einer Digital-Vergleichsschaltung mit vorbestimmbaren Grenzwerten verglichen den Auslösebefehl abgibt, wobei die Meßanordnung sowohl die zeitlichen Verläufe des Stromes (6, 8) als auch der Spannung (7, 9) des Netzes (1) mißt, **dadurch gekennzeichnet,** daß zur schnellen Erkennung von Kurzschlüssen eine Anordnung (22) vorgesehen ist, die die zeitlichen Verläufe von Strom (6, 8, i(nT)) und Spannung (7, 9, u-(nT)) in den zugehörigen Frequenzbereich (Is-(mf)), (Us(mf)) überführt und daß eine Anordnung (8, 9) zur Filterung des gemessenen Stromes und der Spannung vor den folgenden Untersuchungen vorhanden ist, so daß die komplexen Impedanzen (20) und Leistungen (21) außerhalb der netzfrequenten Anteile ermittelt werden.

2. Anordnung nach Anspruch 1, **dadurch gekennzeichnet,** daß eine Anordnung (22) vorgesehen ist, die eine Identifikationsrechnung durchführt und eine Klassifizierung der elektrischen Parameter des Anlagenteils ausführt.

3. Anordnung nach einem der Ansprüche 1 oder 2, **dadurch gekennzeichnet,** daß eine Anordnung (10, 11) vorgesehen ist, die den Strom und die Spannung nach der Filterung in digitale Zahlenfolgen umsetzt und die die folgenden Untersuchungen mit digital arbeitenden, elektrischen Funktionsbausteinen ausführt.

4. Anordnung nach einem der vorhergehenden Ansprüche, **dadurch gekennzeichnet,** daß eine Anordnung (15, 16) vorgesehen ist, die die digitalen Zahlenfolgen in eine zeitliche Folge von Segmenten zerlegt.

5. Anordnung nach Anspruch 4, **dadurch gekennzeichnet,** daß eine Anordnung (15, 16) vorgesehen ist, die die Zahlenfolgen in eine zeitliche Abfolge von Segmenten mit einer jeweils gleichen Anzahl von Meßwerten zerlegt.

6. Anordnung nach einem der vorhergehenden Ansprüche, **dadurch gekennzeichnet,** daß eine Anordnung (15, 16) vorgesehen ist, die für das jeweilige Segment eine Normierung auf verschwindenden arithmetischen Mittelwert ausführt.

7. Anordnung nach einem der vorhergehenden Ansprüche, **dadurch gekennzeichnet,** daß eine Anordnung (15, 16) vorgesehen ist, durch die eine den Meßwerten des Stromes und der Spannung proportionale Skalierung durchgeführt wird.

8. Anordnung nach einem der vorhergehenden Ansprüche, **dadurch gekennzeichnet,** daß eine Anordnung (17) vorgesehen ist, in der die Kreuzkorrelationsfunktion der gemessenen Spannung und des Stromes gebildet wird.

9. Anordnung nach Anspruch 8, **dadurch gekennzeichnet,** daß eine Anordnung (22) vorgesehen ist, die das Maximum der Kreuzkorrelationsfunktion sowie dessen zeitliche Lage zur Klassifikation des Anlagenzustandes benutzt.

10. Anordnung nach einem der vorhergehenden Ansprüche, **dadurch gekennzeichnet,** daß eine Anordnung (18, 19) vorgesehen ist, die die Fouriertransformierten der gemessenen und gefilterten Spannung und des Stromes bildet.

11. Anordnung nach Anspruch 10, **dadurch gekennzeichnet,** daß eine Anordnung (18, 19) vorgesehen ist, die das konjugiert komplexe Produkt der Fouriertransformierten der Spannung des Stromes für zueinandergehörige Frequenzbereiche bildet.

12. Anordnung nach Anspruch 11, **dadurch gekennzeichnet,** daß eine Anordnung (21) vorgesehen ist, in der der Betrag und die Phase einzelner Frequenzbereiche des konjugiert komplexen Produktes zur Klassifikation des anlagenzustandes benutzt werden.

13. Anordnung nach einem der vorhergehenden Ansprüche, **dadurch gekennzeichnet,** daß eine Anordnung (20) vorgesehen ist, in der der komplexe Quotient der Fouriertransformierten der Spannung und des Stromes für die zueinandergehörigen Frequenzbereiche sowie der Betrag und die Phase einzelner Frequenzbereiche des Quotienten gebildet werden.

14. Anordnung nach einem der vorhergehenden Ansprüche, **dadurch gekennzeichnet,** daß eine Anordnung (14, 22) vorgesehen ist, die abhängig von dem Netz überlagerten höherfrequenten Störspannungen und -ströme des Anlagenteiles die voreingestellten Parameter und Grenzwerte betriebsmäßig selbsttätig nachführt.

15. Anordnung nach einem der vorhergehenden Ansprüche, **dadurch gekennzeichnet,** daß eine Anordnung (14, 22) vorgesehen ist, die abhängig von Netzzustandsänderungen die voreingestellten Parameter und Grenzwerte selbsttätig nachführt.

16. Anordnung nach einem der vorhergehenden Ansprüche, **dadurch gekennzeichnet,** daß mehrere digitale Funktionsbausteine zur parallelen Untersuchung der gemessenen und gefilterten Ströme und Spannungen vorhanden sind.

17. Anordnung nach einem der vorhergehenden Ansprüche, **dadurch gekennzeichnet,** daß eine Anordnung vorgesehen ist, die die einzelnen Segmente sowohl zeitlich überlappend als auch gleichzeitig parallel untersucht.

18. Anordnung nach einem der vorhergehenden Ansprüche, **dadurch gekennzeichnet,** daß eine Anordnung vorgesehen ist, die die zeitliche Abfolge der die einzelnen Segmente charakterisierenden Parameter auswertet.

## Claims

1. An arrangement for detecting errors and for generating an electric trigger command with an electronic measuring and processing arrangement for current values, compared in a digital comparison circuit with predetermined limit values, which delivers the trigger command, wherein the measuring arrangement measures the temporal characteristics of the current (6,8) as well as the voltage (7,9) of the grid (1), characterised in that for rapid detection of short circuits an arrangement (22) is provided which transfers the temporal characteristics of the current (6,8, i(nT)) and voltage (7,9, u(nT)) into the associated frequency domain (Is(mf), Us(mf)) and in that an arrangement (8,9) for filtering the measured current and the voltage before the following examinations is present, so that the complex impedances (20) and outputs (21) are detected outside the power-frequency contents.

2. An arrangement according to claim 1, characterised in that an arrangement (22) is provided, which carries out an identification calculation and executes a classification of the electric parameters of the part of the installation.

3. An arrangement according to one of claims 1 to 2, characterised in that an arrangement (10,11) is provided, which transforms the current and the voltage after filtering into digital number sequences and which executes the following examinations with digitally functioning electric function modules.

4. An arrangement according to one of the preceding claims, characterised in that an arrangement (15, 16) is provided, which separates the digital number sequences into a temporal sequence of segments.

5. An arrangement according to claim 4, characterised in that an arrangement (15, 16) is provided, which separates the number sequences into a temporal sequence of segments having in each case an equal number of measured values.

6. An arrangement according to one of the preceding claims, characterised in that an arrangement (15,16) is provided, which, for the respective segment, executes a standardisation to a diminishing arithmetic mean value.

7. An arrangement according to one of the preceding claims, characterised in that an arrangement (15, 16) is provided, with which a scaling is carried out proportional to the measured values of the current and the voltage.

8. An arrangement according to one of the preceding claims, characterised in that an arrangement (18) is provided, in which the cross-correlation function of the measured voltage and of the current is formed.

9. An arrangement according to claim 8, characterised in that an arrangement (22) is provided, which uses the peak of the cross-correlation function as well as its temporal position for classification of the state of the installation.

10. An arrangement according to one of the preceding claims, characterised in that an arrangement (18,19) is provided, which forms the Fourier transforms of the measured and filtered voltage and of the current.

11. An arrangement according to claim 10, characterised in that an arrangement (18, 19) is provided, which forms the conjugate-complex product of the Fourier transform of the voltage (and) of the current for frequency domains associated with each other.

12. An arrangement according to claim 11, characterised in that an arrangement (21) is provided, in which the magnitude and the phase of individual frequency domains of the conjugate-complex product are used for classification of the state of the installation.

13. An arrangement according to one of the preceding claims, characterised in that an arrangement (20) is provided in which the complex quotient of the Fourier transforms of the voltage and of the current for the frequency domains associated with each other, as well as the amount and the phase of the individual frequency domains of the quotient, are formed.

14. An arrangement according to one of the preceding claims, characterised in that an arrangement (14, 22) is provided which, in dependence on higher-frequency interfering voltages and currents of the part of the installation, which are superimposed on the grid, automatically follows-up the preset parameters and limit values operationally.

15. An arrangement according to one of the preceding claims, characterised in that an arrangement (14, 22) is provided which, in dependence on the alterations of the state of the grid automatically tracks the preset parameters and the limit values.

16. An arrangement according to one of the preceding claims, characterised in that several digital function modules are present for parallel examination of the measured and filtered currents and voltages.

17. An arrangement according to one of the preceding claims, characterised in that an arrangement is provided which examines the individual segments in a temporally overlapping manner as well as simultaneously parallel.

18. An arrangement according to one of the preceding claims, characterised in that an arrangement is provided which evaluates the temporal sequence of the parameters characterising the individual segments.

**Revendications**

1. Dispositif pour identifier des défauts et produire une instruction de déclenchement électrique, comportant un dispositif électronique de mesure et de traitement pour des valeurs d'intensité, qui délivre l'instruction de déclenchement, sur la base d'une comparaison à des valeurs limites pouvant être prédéterminées, dans un circuit comparateur numérique, le dispositif de mesure mesurant aussi bien les variations dans le temps du courant (6,8) que de la tension (7,9) du réseau (1), caractérisé par le fait que pour la détermination rapide de courts-circuits, il est prévu un dispositif (22), qui convertit les variations dans le temps du courant $(6,8,i(nT))$ et de la tension $(7,9,u(nT))$ en les amenant dans la gamme associée de fréquences $(Is(mf),Us(mf))$ et qu'il est prévu un dispositif (8,9) pour filtrer le courant mesuré et la tension avant les examens ultérieurs de sorte que les impédances complexes (20) et les puissances complexes (21) sont déterminées en dehors des composantes à basse fréquence.

2. Dispositif suivant la revendication 1, caractérisé par le fait qu'il est prévu un dispositif (22) qui exécute un calcul d'identification et une classification des paramètres électriques de la partie de l'installation.

3. Dispositif suivant la revendication 1 ou 2, caractérisé par le fait qu'il est prévu un dispositif (10,11), qui convertit le courant et la tension après filtrage, en des suites numériques de chiffres et qui exécute les examens ultérieurs au moyen de modules fonctionnels électriques à fonctionnement numérique.

4. Dispositif suivant l'une des revendications précédentes, caractérisé par le fait qu'il est prévu un dispositif (15,16), qui subdivise les suites numériques de chiffres en une suite temporelle de segments.

5. Dispositif suivant la revendication 4, caractérisé par le fait qu'il est prévu un dispositif (15,16), qui subdivise les suites de chiffres en une succession temporelle de segments comportant chacun le même nombre de valeurs de mesure.

6. Dispositif suivant l'une des revendications précédentes, caractérisé par le fait qu'il est prévu un dispositif (15,16), qui exécute, pour le segment respectif, une normalisation sur une valeur arithmétique moyenne qui s'annule.

7. Dispositif suivant l'une des revendications précédentes, caractérisé par le fait qu'il est prévu un dispositif (15,16), qui exécute un cadrage proportionnel aux valeurs de mesure du courant et de la tension.

8. Dispositif suivant l'une des revendications précédentes, caractérisé par le fait qu'il est prévu un dispositif (17), dans lequel la fonction de corrélation croisée de la tension mesurée du courant est formée.

9. Dispositif suivant la revendication 8, caractérisé par le fait qu'il est prévu un dispositif (22) qui utilise le maximum de la fonction de corrélation croisée ainsi que sa position dans le temps, pour classer l'état de l'installation.

10. Dispositif suivant l'une des revendications précédentes, caractérisé par le fait qu'il est prévu un dispositif (18,19), qui forme la transformée de Fourier de la tension mesurée filtrée et du courant.

11. Dispositif suivant la revendication 10, caractérisé par le fait qu'il est prévu un dispositif (18,19), qui forme le produit complexe conjugué de la transformée de Fourier de la tension et du courant pour des gammes de fréquences réciproquement associées.

12. Dispositif suivant la revendication 11, caractérisé par le fait qu'il est prévu un dispositif (21), dans lequel la valeur absolue et la phase de gammes individuelles de fréquences du produit complexe conjugué sont utilisées pour la classification de l'état de l'installation.

13. Dispositif suivant l'une des revendications précédentes, caractérisé par le fait qu'il est prévu un disposiif (20), dans lequel le quotient complexe de la transformée de Fourier de la tension et du courant pour les gammes de fréquence associées entre elles ainsi que la valeur absolue de la phase de gammes individuelles de fréquences du quotient sont formées.

14. Dispositif suivant l'une des revendications précédentes, caractérisé par le fait qu'il est prévu un dispositif (14,22), qui asservit automatiquement, les paramètres et valeurs limites préréglés en fonction des tensions et courants parasites à des fréquences accrues de la partie de l'installation, qui sont superposées au réseau.

15. Dispositif suivant l'une des revendications précédentes, caractérisé par le fait qu'il est prévu un dispositif (14,22), qui asservit automatiquement les paramètres et valeurs limites préréglés, en fonction de variations de l'état du réseau.

16. Dispositif suivant l'une des revendications précédentes, caractérisé par le fait que plusieurs modules fonctionnels numériques sont prévus pour l'examen en parallèle des courants et tensions mesurés et filtrés.

17. Dispositif suivant l'une des revendications précédentes, caractérisé par le fait qu'il est prévu un dispositif qui examine les segments individuels aussi bien en chevauchement dans le temps que simultanément en parallèle.

18. Dispositif suivant l'une des revendications précédentes, caractérisé par le fait qu'il est prévu un dispositif qui évalue la succession dans le temps des paramètres caractérisant les segments individuels.

FIG 1

FIG 2